# EUROPEAN PATENT SPECIFICATION

(11) **EP 4 133 519 B1**
(45) Date of publication and mention of the grant of the patent: **27.12.2023**
(21) Application number: 21707241.2
(22) Date of filing: 19.02.2021
(51) Int. Cl.: H01L 21/683

(54) **CLAMPING DEVICE AND METHOD FOR SMOOTHING A CURVED SAMPLE**
KLEMMVORRICHTUNG UND VERFAHREN ZUM GLÄTTEN EINER GEKRÜMMTEN PROBE
DISPOSITIF DE SERRAGE ET PROCÉDÉ DE LISSAGE D'UN ÉCHANTILLON INCURVÉ

(30) Priority: 09.04.2020 DE 102020109996
(43) Date of publication of application: 15.02.2023
(73) Proprietor: FRT GmbH, 51429 Bergisch Gladbach (DE)
(72) Inventor: AVELLÁN HAMPE, Alejandro, 51429 Bergisch Gladbach (DE); MEYER, Reinhard Matthias, 51429 Bergisch Gladbach (DE); SCHMIDT, Jochen, 51429 Bergisch Gladbach (DE)
(74) Representative: Schmidt, Alexander
(86) International application number: PCT/EP2021/054212
(87) International publication number: WO 2021/204452

(56) References cited:
- US-A1- 2015 240 358
- US-A1- 2018 108 559
- US-B1- 7 396 022

## Description

### CROSS-RELATION TO OTHER APPLICATIONS

This application claims the priority of and benefit to German Patent Application DE 10 2020 109 996 A1 filed on 9 April 2020.

### FIELD OF THE INVENTION

The present invention, which is defined by the appended claims, relates to a clamping device for smoothing a curved sample, in particular a curved semiconductor wafer. Furthermore, the present invention relates to a method for smoothing a curved sample, in particular a curved semiconductor wafer, and also to uses of a clamping device.

### BACKGROUND TO THE INVENTION

Semiconductor components such as logic devices and memory devices are usually fabricated by a sequence of processing steps applied to a sample. The various features and multiple structural levels of the semiconductor components are formed through these processing steps. For example, lithography is a semiconductor manufacturing process that involves the creation of a pattern ("patterning") on a semiconductor wafer. Other examples of the semiconductor manufacturing processes include chemical mechanical polishing and etching, deposition, and ion implantation. A large number of the semiconductor components can be fabricated on a single semiconductor wafer and can then be separated into individual semiconductor components.

A wafer is positioned within a wafer processing tool (e.g., lithography equipment, etching tool, inspection tool, metrology tool) by clamping the thin wafer onto a clamping device, in particular a flat wafer chuck (holder). The clamping device, or wafer chuck, is a machine part that forms the interface between the wafer and the rest of the machine. The wafer is precisely positioned within the tool by accurately controlling the movements of the wafer chuck to which the wafer is attached. Because the wafers themselves are very thin (for example, about 200 microns to 1.5 millimeters thick) and have a relatively large diameter (for example, about 200 to 300 millimeters or more), the shape of a wafer in its unconstrained (i.e., unsupported) state is not particularly stable, this especially applies for the flatness of the wafer. During processing, the wafer is clamped to the wafer chuck over a large portion of its rear surface. By forcing the wafer to conform to the shape of the wafer chuck, the wafer chuck flattens the wafer so that wafer processing and inspection tasks can be successfully completed.

In addition to mechanical clamping, it is known to clamp the wafers to the clamping device or the wafer chuck by vacuum. When the wafer is lowered onto the clamping device or wafer chuck, the rear of the wafer comes into contact with the wafer chuck and covers the vacuum channels embedded into the surface of the wafer chuck. When the wafer covers the vacuum channels, the vacuum applied to the channels effectively pulls the wafer onto the surface of the wafer chuck and holds the wafer in the clamped position as long as the vacuum is maintained on the channels.

Clamping the wafer to the surface of the wafer chuck with vacuum is problematic if the wafer is severely curved. In some examples, 300 millimeter diameter wafers have flatness deviations ranging from about 500 microns to several millimeters (for example, about 8-10 millimeters). When a wafer is severely curved, the wafer does not evenly cover the vacuum channels of the wafer chuck. This results in large vacuum leakage, which reduces the clamping force exerted by each vacuum channel. In many scenarios, the reduced clamping force cannot achieve the sufficient force required to pull the wafer from its deformed state onto the wafer chuck. Consequently, the wafer chuck cannot adequately clamp the wafer and further processing of the wafer is not possible without additional intervention. In some scenarios, increased vacuum flow is able to compensate for the large vacuum leakage and generate enough force to successfully clamp the wafer. However, the use of the high vacuum flow is often undesirable from both design and operational perspectives (for example, increased design complexity and cost). In some scenarios, the increased vacuum flow is not sufficient to overcome large leakage generated by severely curved wafers. In these scenarios, the severely curved wafer may need to be discarded or specially (re)processed to reduce warpage. For the curved wafers, devices with air extraction channels that operate according to Bernoulli's principle are also used. However, devices based on the Bernoulli principle are limited in their suction power.

U.S. Patent Application no. U.S. 2015 / 0 240 358 A1 describes a susceptor with a body having a first surface, a second surface opposite the first surface, and an outer side surface connecting the first surface and the second surface. The known susceptor has at least one pocket recessed from the first surface to accommodate at least one wafer therein. The susceptor has at least one tunnel located below the pocket and extending from a center of the body to the outer side surface. The susceptor has at least one connecting channel which connects to the pocket to the tunnel. The susceptor has a supply line connected to the tunnel at the center of the body and supplying a gas from an outside in order for the gas to flow from the center of the body to the outer side surface.

U.S. Patent US 7 396 022 B1 discloses a chuck having a vacuum groove that is capable of holding a wafer as the chuck rotates on a spindle. As the chuck rotates the air pressure above the center of the wafer is reduced. In order to reduce the bowing of the wafer that can result from this low pressure area above the wafer, the invention introduces venturi holes in the chuck which reduces the air pressure in the area below the wafer.

U.S. Patent Application US 2018/108559 A1 discloses methods and systems for vacuum mounting a warped, thin substrate onto a flat chuck. A vacuum chuck includes three or more collapsible bellows that move above the chuck and into contact with a warped substrate. The bellows seal and vacuum clamp onto the backside surface of the substrate. In some embodiments, the bellows collapse by at least five hundred micrometers while clamping. An extensible sealing element is mounted in a recessed annular channel on the surface of the chuck body. As the substrate moves toward the chucking surface, the extensible sealing element extends at least five millimeters above the chuck body and into contact with the substrate. As the space between the chuck and the substrate is evacuated, the extensible sealing element collapse into the recessed annular channel, and the substrate is clamped onto the flat chucking surface of chuck body.

In the prior art there is a risk that the wafer with the semiconductor components is not held sufficiently on the device and slips. In this case, the production or measurement processes cannot be carried out on the sample, in particular on the wafer and on the semiconductor components.

### SUMMARY OF THE INVENTION

It is therefore an object of the present invention to provide a clamping device and a method for smoothing a sample, in particular a semiconductor wafer with semiconductor components, in order to improve the clamping of strongly curved samples, in particular strongly curved semiconductor wafers with semiconductor components.

In view of the known technology and according to a first aspect of the present disclosure, a clamping device for smoothing a curved sample is provided, the clamping device comprises a clamping body. The clamping body comprises a flat clamping surface formed on the surface of the body. The clamping surface at least partially receives the curved sample. A first channel is formed in the clamping body. The first channel has a channel inlet and a channel outlet, wherein the first channel has at least one recess between the channel inlet and the channel outlet that completely penetrates or pierces the clamping body to the clamping surface. A cavity is formed between a lower surface of the curved sample and the recess, wherein a directed air flow flows through the cavity from the channel inlet to the channel outlet. The clamping body comprises at least a second channel having a channel inlet and a channel outlet, wherein the channel outlet being formed on the clamping surface, and wherein the second channel is configured as a vacuum channel.

In one aspect, the clamping device is configured such that at least two or more first channels are formed in the clamping body.

In one aspect, the clamping device is configured such that the first channel is configured as a Venturi channel.

In one aspect, the clamping device is configured such that the clamping body is formed of aluminum, in particular an aluminum alloy, in particular AlMg4.5Mn.

In one aspect, the clamping device is configured to include a mechanical clamp for holding the sample.

In view of the known technology and according to a second aspect of the present disclosure, there is provided a method for smoothing a curved sample. The method thereby comprises the steps of: receiving a curved sample on a flat clamping surface of a clamping body of a clamping device; introducing a directed air flow into a channel inlet of a first channel formed in the clamping body, wherein the directed air flow flows from the channel inlet to the channel outlet; generating a pressure difference by the directed air flow flowing through a cavity, wherein the cavity is formed between at least one recess completely penetrating or piercing the clamping body up to the clamping surface and the lower surface of the curved sample received on the clamping surface; smoothing the curved sample by the generated pressure difference; and holding the smoothed sample by a vacuum cup attached to a channel outlet of a second channel.

In one aspect, the method further comprises holding the smoothed sample by a mechanical clamp.

Furthermore, the clamping device according to the present invention is used according to any of the preceding aspects for smoothing a curved sample, in particular curved wafers, in particular curved wafers having a curvature of about 20 mm.

Further, according to any of the preceding aspects, the clamping device of the invention is used for smoothing a curved sample and holding the smoothed sample for transporting the sample with a robotic arm.

### DESCRIPTION OF THE DRAWINGS

Further features and advantages of the invention will be apparent from the following description, which is purely exemplary and in no way limiting, of preferred aspects of the invention with reference to the accompanying drawings, therein:
Figure 1 is a perspective top view of a clamping device 100 according to a first aspect;
Figure 2 shows the clamping device 100 of the first aspect with a schematically placed curved sample 1;
Figure 3 is a perspective side view of a clamping device 200 of a second aspect with a curved sample 1;
Figure 4 is a side elevational view of the clamping device 100, 200 according to one of the aspects with the curved sample 1; and
Figure 5 is a flow chart of the method for smoothing a curved sample 1.

### DETAILED DESCRIPTION OF THE INVENTION

Selected aspects will now be described with reference to the drawings. It will be apparent to one skilled in the art of clamping devices for smoothing samples, particularly semiconductor wafers containing semiconductor components, from this disclosure that the following description of aspects are provided for illustrative purposes only, and not for the purpose of limiting the invention defined by the appended claims and their equivalents.

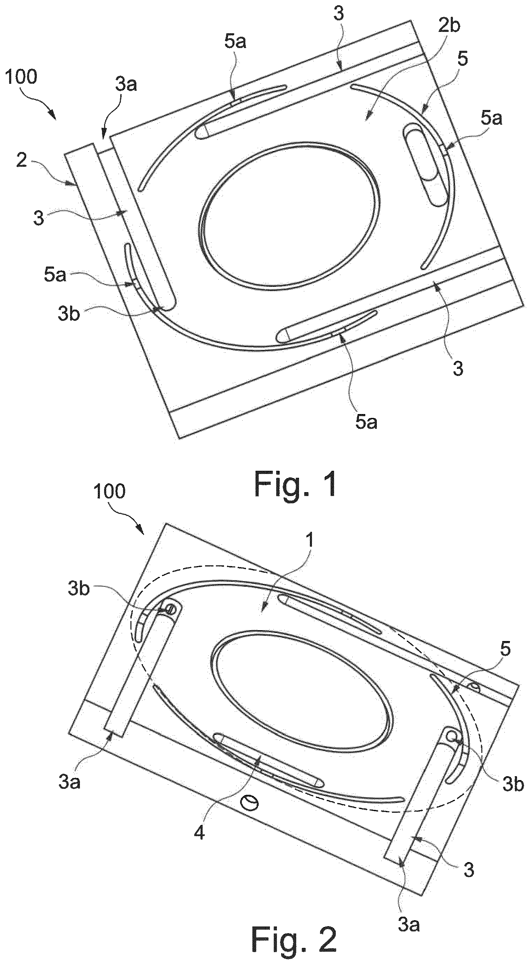

Initially, referring to Fig. 1, a perspective top view of a clamping device 100 is shown according to a first aspect of the present invention. As can be seen in Fig. 1, the clamping device 100 comprises a clamping body 2 for smoothing a curved sample 1. The clamping body 2 may be formed, for example, of aluminum, for example, of an aluminum alloy, for example, of AlMg4.5Mn. Further, for example, the material of the clamping body 2 may be anodized. However, the present aspect is not limited thereto, so that other materials may also be used for the clamping body 2, if needed and/or desired. As can be seen in Figure 1, the clamping body 1 has a body surface 2a. A substantially flat clamping surface 2b is formed on the body surface 2a. The flat clamping surface 2b is configured to receive at least partially the curved sample 1, in particular a curved semiconductor wafer 1. The body surface 2a may also fully coincide with the clamping surface 2b, if needed and/or desired.

As can be seen in Fig. 1, the clamping body 2 has at least one first channel 3. In the aspect in Fig. 1, the clamping body 2 has two opposing first channels 3. In particular, two pairs of opposing first channels 3 are formed in the clamping body 2. Each of the first channels 3 has at least one channel inlet 3b and at least one channel outlet 3a. As can be seen in Fig. 1, the first channels 3 extend through the clamping body 2 in a straight line parallel to the body surface 2a. However, the present aspect is not limited thereto, so that the clamping body 2 may also have annular first channels 3 or first channels 3 that do not extend in a straight line, if needed and/or desired. As can be seen in Figs. 1 and 2, the first channel 3 has at least one recess 4 between the channel inlet 3b and the channel outlet 3a, completely penetrating or piercing the clamping body 2 up to the clamping surface 2b. As can be seen schematically in Fig. 2, the curved sample 1 at least partially covers the first channels 3. As can be seen schematically in Fig. 2, the curved sample 1 at least partially covers the recess 4 completely penetrating or piercing the clamping body 2 up to the clamping surface 2b.

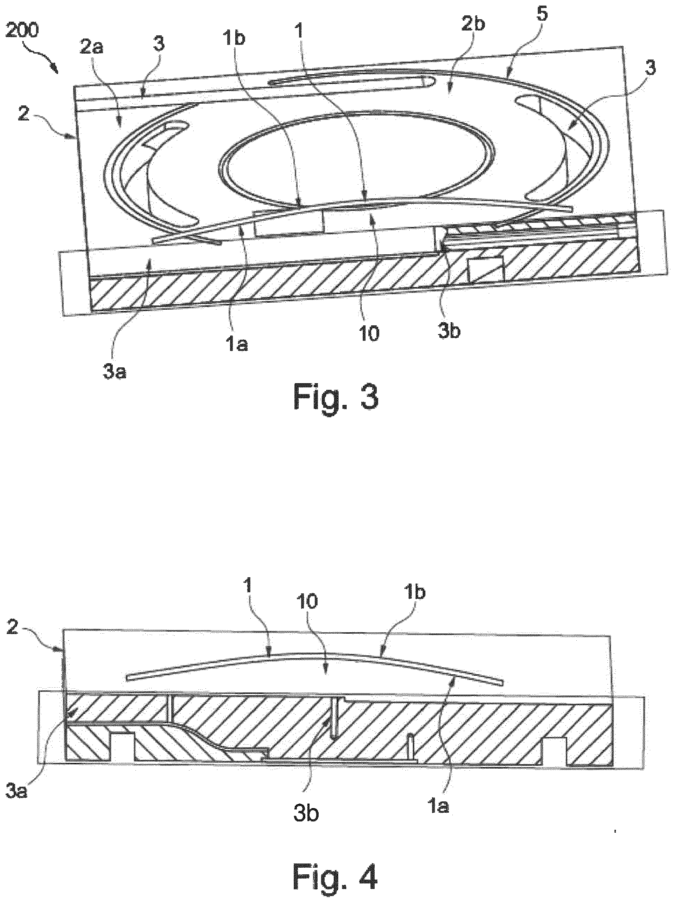

Figure 4 shows a side elevation view of the clamping device 100 according to the first aspect. As can be seen in Fig. 4, a cavity 10 is formed between a lower surface 1a of the curved sample 1 lying on the clamping surface 2b and the recess 4. In the clamping device 100, a suction effect on the curved sample 1 is achieved by the air flow directed through the first channel 3 in interaction with the sample 1 to be smoothed, wherein the air flow is blown into the first channel 3 and is directed from the channel inlet 3b to the channel outlet 3a. The directed air flow thereby flows through the recess 4 arranged between the channel inlet 3b and the channel outlet 3a, whereby the air flow flowing through the cavity 10 thereby generates a pressure difference. In the clamping device 100, the suction force is thus achieved in the interaction between the directed air flow in the first channel 3 and the curved sample 1. The curvature of the curved sample 1, which is accommodated on the clamping surface 2b, thereby generates the pressure difference required to smooth the curved sample 1 on the clamping surface 2b. Accordingly, the clamping device 100 exploits the so-called Venturi principle to smooth the curved sample 1 on the clamping surface 2b of the clamping device 100. Consequently, the at least one first channel 3 is formed as a Venturi channel. The clamping device 100 can be used for smoothing a curved sample 1, in particular curved semiconductor wafers 1, with a curvature of up to about 20 mm.

Furthermore, as can be seen in Fig. 1, the clamping body 2 according to the first aspect may comprise at least one second channel 5 in addition to the first channel 3. In the aspect shown in Fig. 1, the clamping body comprises three second channels 5. Each of the second channels 5 has at least one channel inlet 5b and at least one channel outlet 5a. As can be seen in Fig. 1, the second channels 5 each extend annularly through the clamping body 2. However, the present aspect is not limited thereto, such that the clamping body 2 may also have second channels 5 extending in a straight line if needed and/or desired. Furthermore, as can be seen in Figures 1 and 2, the channel outlet 5a is formed on the clamping surface 2b of the clamping body 2. The second channel 5 is formed as a vacuum channel. A vacuum is generated by vacuum cups each applied to the channel inlet 5b of the second channel 5 via the channel outlet 5a located on the clamping surface 2b of the clamping body 2. The sample 1 at least partially covers at least one of the channel outlets 5a of the second channels 5, and a clamping force is applied via the second channels 5 to the sample 1 which has been smoothed by the pressure difference. Consequently, the clamping device 100 may additionally hold the sample 1, which has been smoothen by the Venturi principle and by a clamping force generated by vacuum. Furthermore, the curved sample 1 can also be smoothed by the Venturi principle and by the vacuum generated on the clamping surface 2b of the clamping body 2. Furthermore, as an alternative to the second channels 5 or in addition to the second channels 5, the clamping device 100 comprise a mechanical clamp (not shown) for holding the smoothed sample 1 if needed and/or desired. The clamping device 100 for smoothing the curved sample 1 by the Venturi principle and holding the smoothed sample 1 the clamping force by vacuum may further be used for transporting the sample 1 by a robotic arm. However, the present aspect is not limited thereto, such that the clamping device 100 comprises only first channels 3 formed as Venturi channels, if needed and/or desired.

In Fig. 3, a second aspect of a clamping device 200 according to the present invention is shown, wherein the second aspect comprises all features of the first aspect, so that these are not described again in detail for the sake of brevity and are designated with the same reference signs as in the first aspect. However, as can be seen in Fig. 3, in contrast to the first aspect shown in Figs. 1 and 2, the first channels 3 have both channels 3 extending in a straight line and annular channels 3. In particular, as shown in Fig. 3, a pair of opposing first channels 3 extending in a straight line is formed in the clamping body 2. Further, as shown in Fig. 3, a pair of opposing annularly extending first channels 3 is formed in the clamping body 2. Figure 4 also shows a side elevation view of the clamping device 200 according to the second aspect.

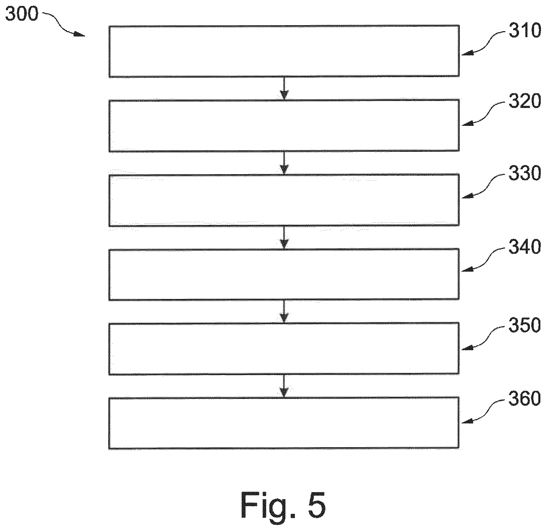

Figure 5 shows a flow chart of the method for smoothing a curved sample 1 according to the present invention. The method for smoothing a curved sample 1 comprises receiving 310 the curved sample 1 on the flat clamping surface 2b of the clamping body 2 of a clamping device 100, 200. Further, the method comprises introducing or blowing 320 a directed air flow into the channel inlet 3b of the first channel 3 formed in the clamping body 2, wherein the directed air flow flows from the channel inlet 3b to the channel outlet 3a. Further, the method comprises generating 330 a pressure difference by the directed air flow passing through the cavity 10, the cavity 10 being formed between at least the recess 4 completely penetrating or piercing the clamping body 2 up to the clamping surface 2b and the lower surface 1a of the curved sample received on the clamping surface. Furthermore, the method comprises a smoothing 340 of the curved sample 1 by the generated pressure difference. Further, the method comprises holding (350) the smoothed sample 1 by a vacuum cup attached to the channel inlet 5b of the second channel 5. Further, the method comprises holding 360 the smoothed sample 1 by the mechanical clamp (not shown).

### Reference Numerals

- 1: curved sample
- 1a: lower surface
- 2: clamping body
- 2a: body surface
- 2b: clamping surface
- 3: first channel
- 3a: channel outlet
- 3b: channel inlet
- 4: recess
- 5: second channel
- 5a: channel outlet
- 5b: channel inlet
- 10: recess
- 100, 200: clamping device

## Claims

1. A clamping device (100, 200) for smoothing a curved sample (1), comprising:
a clamping body (2) having a flat clamping surface (2b) formed on the body surface (2a), wherein the clamping surface (2b) at least partially receives the curved sample (1);
a first channel (3) formed in the clamping body (2) and having a channel inlet (3b) and a channel outlet (3a), wherein the first channel (3) has at least one recess (4) between the channel inlet (3b) and the channel outlet (3a) completely penetrating the clamping body (2) up to the clamping surface (2b), wherein a cavity (10) is formed between a lower surface (1a) of the curved sample (1) and the recess (4), and wherein a directed air flow flows through the cavity (10) from the channel inlet (3b) to the channel outlet (3a), and wherein the clamping body (2) comprises at least one second channel (5) having a channel inlet (5b) and a channel outlet (5a), wherein the channel outlet (5a) being formed on the clamping surface (2b), and wherein the second channel (5) is formed as a vacuum channel.

2. The device (100, 200) according to claim 1, wherein at least two opposing first channels (3) are formed in the clamping body (2)

3. The device (100, 200) according to claim 1 or 2, wherein the first channel (3) is formed as a Venturi channel.

4. The device (100, 200) according to any one of claims 1 to 3, wherein the clamping body (2) is formed from aluminum, in particular from an aluminum alloy, in particular from AlMg4.5Mn.

5. A method (300) for smoothing a curved sample, comprising the steps of:
receiving (310) a curved sample (1) on a flat clamping surface (2b) of a clamping body (2) of a clamping device (100);
introducing (320) a directed air flow into a channel inlet (3b) of a first channel (3) formed in the clamping body (2), the directed air flow flowing from the channel inlet (3b) to a channel outlet (3a);
creating (330) a pressure difference by the directed air flow, the directed air flow passing through a cavity (10), the cavity (10) being formed between at least one recess (4) completely penetrating the clamping body (2) up to the clamping surface (2a) and the lower surface (1a) of the curved sample (1) received on the clamping surface (2a);
smoothing (340) of the curved sample (1) by the generated pressure difference; and holding (350) the smoothed sample (1) by a vacuum cup attached to a channel inlet (5b) of a second channel (5).

6. The method (300) of claim 5, further comprising: holding (360) the smoothed sample (1) by a mechanical clamp.

7. The use of a clamping device (100) according to claims 1 to 4 for smoothing a curved sample (1), in particular curved wafers (1), in particular curved wafers with a curvature of about 20 mm.

8. The use of a clamping device (100) according to claim 7 for also holding the smoothed sample (1).

9. The use of a clamping device (100) according to claim 1 for smoothing a curved sample (1) and holding the smoothed sample (1) for transporting the sample (1) with a robotic arm.

## Patentansprüche

1. Klemmvorrichtung (100, 200) zum Glätten einer gekrümmten Probe (1), umfassend:
einen Klemmkörper (2) mit einer auf der Körperfläche (2a) ausgebildeten flachen Klemmfläche (2b), wobei die Klemmfläche (2b) die gekrümmte Probe (1) zumindest teilweise aufnimmt;
einen im Klemmkörper (2) ausgebildeten ersten Kanal (3) mit einem Kanaleinlass (3b) und einem Kanalauslass (3a), wobei der erste Kanal (3) zwischen dem Kanaleinlass (3b) und dem Kanalauslass (3a) mindestens eine Aussparung (4) aufweist, die den Klemmkörper (2) bis zur Klemmfläche (2b) vollständig durchdringt, wobei zwischen einer Unterseite (1a) der gekrümmten Probe (1) und der Aussparung (4) ein Hohlraum (10) ausgebildet ist, und wobei ein gerichteter Luftstrom durch den Hohlraum (10) vom Kanaleinlass (3b) zum Kanalauslass (3a) strömt, und wobei der Klemmkörper (2) mindestens einen zweiten Kanal (5) mit einem Kanaleinlass (5b) und einem Kanalauslass (5a) umfasst, wobei der Kanalauslass (5a) auf der Klemmfläche (2b) ausgebildet ist, und wobei der zweite Kanal (5) als Vakuumkanal ausgebildet ist.

2. Vorrichtung (100, 200) nach Anspruch 1, wobei in dem Klemmkörper (2) mindestens zwei gegenüberliegende erste Kanäle (3) ausgebildet sind

3. Vorrichtung (100, 200) nach Anspruch 1 oder 2, wobei der erste Kanal (3) als Venturikanal ausgebildet ist.

4. Vorrichtung (100, 200) nach einem der Ansprüche 1 bis 3, wobei der Klemmkörper (2) aus Aluminium, insbesondere aus einer Aluminiumlegierung, insbesondere aus AlMg4.5Mn, ausgebildet ist.

5. Verfahren (300) zum Glätten einer gekrümmten Probe, umfassend die Schritte:
Aufnehmen (310) einer gekrümmten Probe (1) auf einer flachen Klemmfläche (2b) eines Klemmkörpers (2) einer Klemmvorrichtung (100);
Einleiten (320) eines gerichteten Luftstroms in einen Kanaleinlass (3b) eines in dem Klemmkörper (2) ausgebildeten ersten Kanals (3), wobei der gerichtete Luftstrom vom Kanaleinlass (3b) zu einem Kanalauslass (3a) strömt;
Erzeugen (330) einer Druckdifferenz durch den gerichteten Luftstrom, wobei der gerichtete Luftstrom einen Hohlraum (10) durchläuft, wobei der Hohlraum (10) zwischen mindestens einer Aussparung (4), die den Klemmkörper (2) bis zur Klemmfläche (2a) vollständig durchdringt, und der unteren Fläche (1a) der auf der Klemmfläche (2a) aufgenommenen gekrümmten Probe (1) ausgebildet ist;
Glätten (340) der gekrümmten Probe (1) durch die erzeugte Druckdifferenz; und Halten (350) der geglätteten Probe (1) durch einen an einem Kanaleinlass (5b) eines zweiten Kanals (5) befestigten Vakuumbecher.

6. Verfahren (300) nach Anspruch 5, weiter umfassend: Halten (360) der geglätteten Probe (1) durch eine mechanische Klemme.

7. Verwendung einer Klemmvorrichtung (100) nach den Ansprüchen 1 bis 4 zum Glätten einer gekrümmten Probe (1), insbesondere von gekrümmten Wafern (1), insbesondere von gekrümmten Wafern mit einer Krümmung von etwa 20 mm.

8. Verwendung einer Klemmvorrichtung (100) nach Anspruch 7 auch zum Halten der geglätteten Probe (1).

9. Verwendung einer Klemmvorrichtung (100) nach Anspruch 1 zum Glätten einer gekrümmten Probe (1) und Halten der geglätteten Probe (1) zum Transportieren der Probe (1) mit einem Roboterarm.

## Revendications

1. Dispositif de serrage (100, 200) pour lisser un échantillon incurvé (1), comprenant :
un corps de serrage (2) ayant une surface de serrage plate (2b) formée sur la surface du corps (2a), dans lequel la surface de serrage (2b) reçoit au moins partiellement l'échantillon incurvé (1) ;
un premier canal (3) formé dans le corps de serrage (2) et ayant une entrée de canal (3b) et une sortie de canal (3a), dans lequel le premier canal (3) a au moins un évidement (4) entre l'entrée de canal (3b) et la sortie de canal (3a) pénétrant complètement le corps de serrage (2) jusqu'à la surface de serrage (2b), dans lequel une cavité (10) est formée entre une surface inférieure (1a) de l'échantillon incurvé (1) et l' évidement (4), et dans lequel un flux d'air directionnel s'écoule à travers la cavité (10) de l'entrée de canal (3b) à la sortie de canal (3a), et dans lequel le corps de serrage (2) comprend au moins un deuxième canal (5) ayant une entrée de canal (5b) et une sortie de canal (5a), la sortie de canal (5a) étant formée sur la surface de serrage (2b), et dans lequel le deuxième canal (5) est formé en tant que canal de vide.

2. Dispositif (100, 200) selon la revendication 1, dans lequel au moins deux premiers canaux opposés (3) sont formés dans le corps de serrage (2).

3. Dispositif (100, 200) selon la revendication 1 ou 2, dans lequel le premier canal (3) est formé en tant que canal Venturi.

4. Dispositif (100, 200) selon l'une quelconque des revendications 1 à 3, dans lequel le corps de serrage (2) est formé à partir d'aluminium, en particulier à partir d'un alliage d'aluminium, en particulier d'AlMg4.5Mn.

5. Procédé (300) pour lisser un échantillon incurvé, comprenant les étapes suivantes :
recevoir (310) un échantillon incurvé (1) sur une surface de serrage plate (2b) d'un corps de serrage (2) d'un dispositif de serrage (100) ;
introduire (320) un flux d'air directionnel dans une entrée de canal (3b) d'un premier canal (3) formé dans le corps de serrage (2), le flux d'air directionnel s'écoulant de l'entrée de canal (3b) vers une sortie de canal (3a) ;
créer (330) une différence de pression par le flux d'air directionnel, le flux d'air directionnel passant à travers une cavité (10), la cavité (10) étant formée entre au moins un évidement (4) pénétrant complètement le corps de serrage (2) jusqu'à la surface de serrage (2a) et la surface inférieure (1a) de l'échantillon incurvé (1) reçu sur la surface de serrage (2a) ;
lisser (340) l'échantillon incurvé (1) par la différence de pression générée ; et maintenir (350) l'échantillon lissé (1) par une ventouse fixée à l'entrée de canal (5b) d'un deuxième canal (5).

6. Procédé (300) selon la revendication 5, comprenant en outre : maintenir (360) l'échantillon incurvé (1) par une pince mécanique.

7. Utilisation d'un dispositif de serrage (100) selon les revendications 1 à 4 pour lisser un échantillon incurvé (1), en particulier des tranches incurvées (1), en particulier des tranches incurvées avec une courbure d'environ 20 mm.

8. Utilisation d'un dispositif de serrage (100) selon la revendication 7 pour maintenir aussi l'échantillon lissé (1).

9. Utilisation d'un dispositif de serrage (100) selon la revendication 1 pour lisser un échantillon incurvé (1) et maintenir l'échantillon lissé (1) pour transporter l'échantillon (1) avec un bras robotisé.
